Europäisches Patentamt

European Patent Office

Office européen des brevets

(19)

(11) Numéro de publication: **0 228 528**
**B1**

## FASCICULE DE BREVET EUROPEEN

(12)

(45) Date de publication du fascicule du brevet:
**11.07.90**

(51) Int. Cl.⁵: **H03M 5/14**, H04L 25/49, G11B 20/14

(21) Numéro de dépôt: **86115074.6**

(22) Date de dépôt: **30.10.86**

(54) **Dispositif de mise en oeuvre d'un code à faible disparité accumulée en transmission numérique à haut débit et procédé de codage utilisant un tel dispositif.**

(30) Priorité: **05.11.85 FR 8516372**

(43) Date de publication de la demande:
**15.07.87 Bulletin 87/29**

(45) Mention de la délivrance du brevet:
**11.07.90 Bulletin 90/28**

(84) Etats contractants désignés:
**BE DE FR GB IT LU NL SE**

(56) Documents cités:
**EP-A- 0 150 082**
**FR-A- 2 012 845**
**FR-A- 2 469 047**
**GB-A- 1 540 617**

**IEEE INTERNATIONAL CONFERENCE ON COMMUNICATIONS, Conference record, vol. 2, 19-22 juin 1983, Boston, US, pages 690-694, IEEE, New York, US; G. HANKE: "Fast 7B/8B coder and decoder for an optical transmission system" SECOND INTERNATIONAL CONFERENCE ON TELECOMMUNICATION TRANSMISSION- INTO THE DIGITAL ERA, 17-20 mars 1981, Londres, GB; pages 213-216; G. LAMPE: "Optical transmission system for a 140 MBit/s subscriber loop" THE BELL SYSTEM TECHNICAL JOURNAL,**

(73) Titulaire: **ALCATEL CIT, 12 Rue de la Baume, F-75008 Paris(FR)**

(72) Inventeur: **Jaffré, Pierre, Résidence Ker Lann, 3 rue Jeanne d'Arc F-22300 Lannion(FR)**
Inventeur: **Niquel, Maurice, Park Ar Sav Heol Rue de Karent Ar Birgorned, F-22700 Perros Guirec(FR)**
Inventeur: **Tanguy, Christian, Kerlin Servel, F-22300 Lannion(FR)**

(74) Mandataire: **Weinmiller, Jürgen et al, Lennéstrasse 9 Postfach 24, D-8133 Feldafing(DE)**

(56) Documents cités: (suite)
**vol. 53, no. 6, juillet-août 1974, pages 1103-1126, American Telephone and Telegraph Company, US; L.J. GREENSTEIN: "Spectrum of a binary signal block coded for DC suppression"**
**FREQUENZ, vol. 34, no. 2, février 1980, pages 45-52, Berlin, DE; R. DRULLMANN et al.: "Leitungscodierung und betriebliche Überwachung bei regenerativen Lichtleitkabel-Übertragungssystemen"**
**ELECTRONICS LETTERS, vol. 5, no. 4, 20 février 1969, pages 79-81; J.M. GRIFFITHS: "Binary code suitable for line transmission"**

## Description

La présente invention se rapporte à un dispositif de mise en oeuvre d'un code à faible disparité accumulée en transmission numérique à haut débit, par exemple à 8 fois 140 mégabits/seconde et à un procédé de codage utilisant un tel dispositif.

Dans le domaine des transmissions numériques telles que ci-dessus définies, il est souhaitable que chaque train d'impulsions binaires, 0 ou 1, qui constitue un signal n'ait pas de composante continue et présente une faible densité d'énergie spectrale dans le domaine des basses-fréquences. En effet les têtes optiques d'émission et de réception utilisées présentent une coupure en basse-fréquence. De plus il est nécessaire de transmettre en basse-fréquence à la fois des informations de service et des informations de télésurveillance qui risquent alors de se brouiller entre elles.

Pour réaliser cette propriété, il est connu, par exemple du document US-A-3.405.235, de découper le train numérique, se propageant en parallèle sur plusieurs voies, en mots transmis en parallèle auxquels on applique un code de bloc conçu pour que la disparité accumulée :

$$\Sigma_n = \sum_{k=0}^{k=n} Sk$$

reste faible; n étant le dernier mot transmis, et Sk la "somme" du mot de rang k telle que : Sk = nombre de "1"- nombre de "0" de ce mot.

Le procédé de codage à disparité accumulée faible tel que décrit dans le document US-A-3.405.235 précité, est le suivant :
- si $\Sigma_{n-1}$ et Sn sont de mêmes signes, le mot, de somme Sn, est inversé, c'est-à-dire que les "0" sont transformés en "1" et vice-versa,
- si $\Sigma_{n-1}$ et Sn sont de signes contraires, le mot, de somme Sn, est transmis tel quel.

Les réalisations antérieures de ce code à faible disparité accumulée mettaient en oeuvre soit des mémoires programmables, inutilisables à l'heure actuelle à haut débit en raison de leurs temps d'accès trop élevés, soit un ou plusieurs additionneurs, dont la fréquence limite est trop faible et le temps de propagation trop élevé pour pouvoir être utilisés dans les mêmes conditions à un débit élevé, de l'ordre de 140 mégabits seconde par exemple.

Pour pallier ces différents inconvénients, l'invention a pour objet l'utilisation de deux unités de calcul de $\Sigma_n = \Sigma_{n-1} + Sn$ et $\Sigma'_n = \Sigma_{n-1} - Sn$ fonctionnant simultanément et en parallèle.

La présente invention présente à cet effet un dispositif de mise en oeuvre d'un code à faible disparité accumulée en transmission numérique, à haut débit, d'informations groupées sous la forme de mots binaires de x digits, un mot de rang n ayant une somme Sn égale à la demi-différence entre le nombre de "1" et nombre de "0" de ce mot, ledit dispositif comprenant un circuit de calcul de cette somme Sn, une unité de calcul de la disparité accumulée

$$\Sigma_n = \sum_{k=0}^{n} Sk,$$

un circuit de comparaison des signes de $\Sigma_{n-1}$ et de Sn, un circuit de codage de ce mot de rang n, un circuit délivrant des signaux d'horloge, caractérisé en ce que l'unité de calcul de la disparité accumulée comprend une première unité de calcul de la somme $\Sigma_n = \Sigma_{n-1} + Sn$ et une deuxième unité de calcul de la différence $\Sigma'_n = \Sigma_{n-1} - Sn$ disposée en parallèle, sur la première le circuit de comparaison de signes de $\Sigma_{n-1}$ et de Sn ayant une sortie reliée directement à une entrée de remise à zéro de la première unité de calcul, à une entrée de validation du circuit de codage, et à une entrée de ce même circuit de codage pour former en sortie un x+1e digit de ce mot, et indirectement, à travers un inverseur, à une entrée de remise à zéro de la deuxième unité de calcul.

L'invention présente le grand avantage de permettre une transmission numérique à débit élevé, par exemple 8 fois 140 mégabits/seconde.

Plus particulièrement l'invention se rapporte à un dispositif caractérisé en ce que la transmission numérique se fait sur plusieurs voies en parallèle, un mot étant alors formé de l'ensemble des informations qui arrivent simultanément sur ces voies.

Les caractéristiques et avantages de l'invention ressortiront d'ailleurs de la description qui va suivre en références aux figures annexées sur lesquelles :

- la figure 1 est une représentation schématique du dispositif de codage de l'invention,
. - la figure 2 est une représentation schématique plus détaillée d'une partie du dispositif de l'invention.
- la figure 3 est un diagramme représentant la phase relative des horloges par rapport à la phase des trains affluents.

Le dispositif de codage de l'invention comprend deux ensembles 8 et 9 disposés en parallèle : d'une part une boucle de calcul 8 de la disparité accumulée $\Sigma_n$ et d'autre part un circuit de codage 9 des mots à transmettre.

En entrée arrivent un ensemble 10 de x voies parallèles qui attaquent ces deux ensembles 8 et 9.

Le premier ensemble 8 comporte un circuit de calcul 11 d'une somme Sn telle que 2 Sn = nombre de "1" binaires - nombre de "0" binaires d'un mot "de rang n" qui est formé de l'ensemble des informations qui entrent en parallèle dans ledit circuit 11.

Ce circuit de calcul de Sn 11 permet de calculer également - Sn.

Un premier et un second circuits additionneurs 12 et 13, dont deux premières séries d'entrées 14 et 15 reliées aux sorties Sn et -Sn du premier circuit 11 permettent de calculer respectivement $\Sigma_{n-1} + Sn$ et $\Sigma_{n-1} - Sn$ ; la disparité accumulée $\Sigma_{n-1}$ étant telle que:

$$\Sigma_{n-1} = \sum_{k=0}^{n-1} Sk$$

Deux secondes séries d'entrées 16 et 17 de ces deux circuits additionneurs 12 et 13 sont reliées aux sorties d'un premier et d'un deuxième échantillonneurs 18 et 19 dont les entrées 20 et 21 sont reliées aux sorties respectives de la ces deux circuits additionneurs 12 et 13.

Un circuit de comparaison 22 des signes de $\Sigma_{n-1}$ et Sn a une première entrée 23 reliée à la sortie du circuit de calcul 11 de Sn correspondant au signe de Sn et une deuxième entrée 24 reliée à l'entrée d'un des deux circuits additionneurs 12 ou 13 qui correspond au signe de $\Sigma_{n-1}$ . Une sortie 25 de ce circuit de comparaison 22 est reliée directement à une entrée de remise à zéro du premier échantillonneur 18 et indirectement à travers un circuit inverseur 26 à une entrée de remise à zéro du deuxième échantillonneur 19.

Le deuxième ensemble 9 comprend un circuit retardateur 30 qui reçoit les x voies 10 d'entrée en parallèle avec le circuit de calcul de Sn 11.

Les x sorties 31 de ce circuit retardateur 30 sont reliées à un circuit de codage 32 des informations véhiculées sur les x voies, qui permet l'inversion ou non de celles-ci.

Un troisième circuit d'échantillonnage 33 est relié aux sorties 34 de ce circuit 32.

L'entrée de validation 35 de ce circuit de codage 32 est reliée à la sortie 25 du circuit comparateur 22 des signes de $\Sigma_{n-1}$ et de Sn ; cette sortie 25 étant également reliée au troisième échantillonneur 33 pour former une x + 1e des voies de sortie 36 de celui-ci.

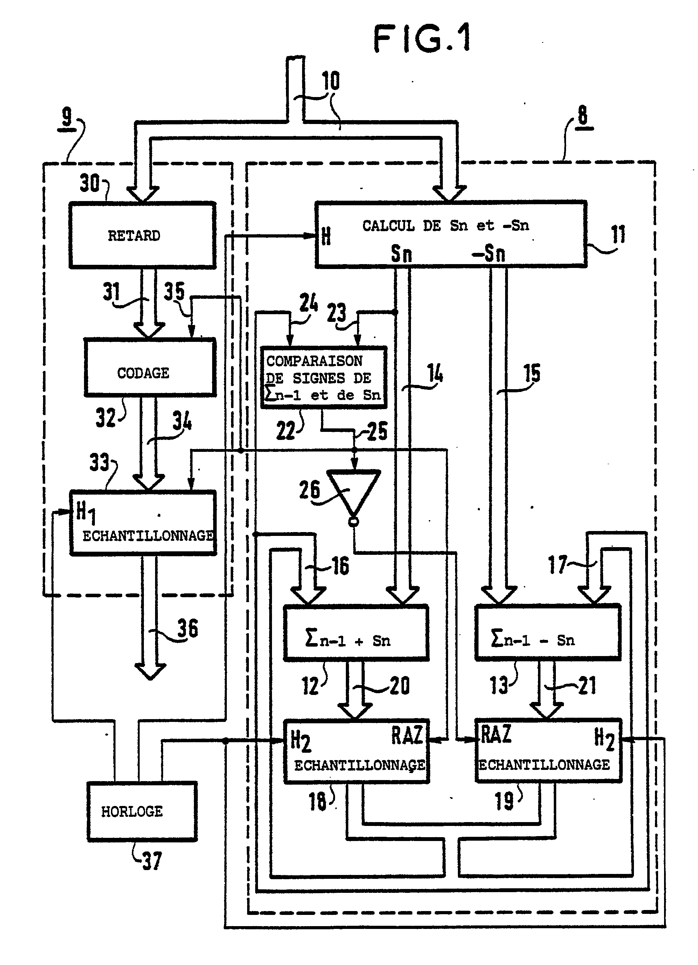

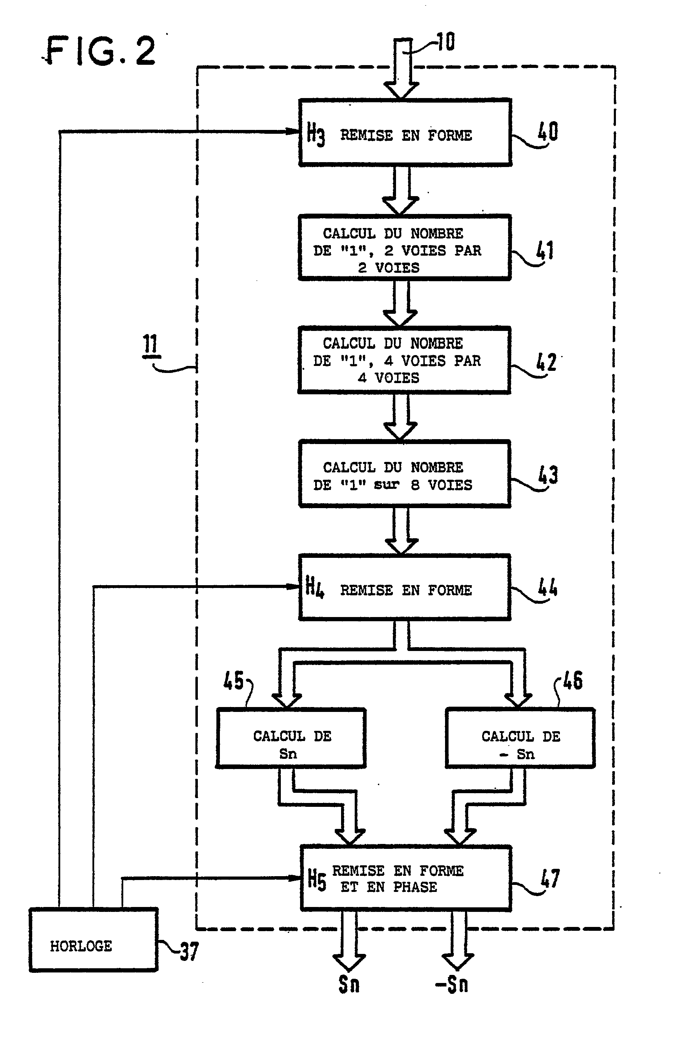

Un circuit horloge 37 délivre différents signaux horloge Hi, de même fréquence mais déphasés les uns par rapport aux autres, au circuit de calcul 11 de Sn et de - Sn et aux différents échantillonneurs 18, 19 et 33, l'entrée H de la figure 1 correspondant aux entrées $H_3$, $H_4$ et $H_5$ de la figure 2.

En fonctionnement les informations arrivent en entrée sous la forme de trains parallèles d'impulsions binaires ; un mot étant formé de l'ensemble des informations qui attaquent simultanément le dispositif de l'invention. Celui-ci permet après obtention de Sn et- Sn, de calculer simultanément à l'aide des deux circuits additionneurs 12 et 13 qui présentent un temps de propagation faible ; $\Sigma_n = \Sigma_{n-1} + Sn$ et $\Sigma'_n = \Sigma_{n-1} - Sn$ pendant que se calcule l'information de comparaison des signes de $\Sigma_{n-1}$ et de Sn.

Le signal de sortie du circuit de comparaison permet lorsque les signes de $\Sigma_{n-1}$ et de Sn sont différents, la remise à zéro du deuxième échantillonneur 19, et lorsqu'ils sont égaux, la remise à zéro du premier échantillonneur 18 et l'inversion 32 de tous les digits du mot de rang n, le $(x + 1)^e$ digit introduit en sortie du troisième échantillonneur 33, qui est alors du niveau "1" permettant de savoir qu'une inversion du mot de rang n a eu lieu.

Le circuit retardateur 30 permet la prise en compte et la comparaison des signes de $\Sigma_{n-1}$ et de Sn avec envoi éventuel d'un signal de validation de l'inversion de tous les digits du mot de rang n en entrée 35 du circuit 32 avant que ce mot de rang n n'arrive en entrée 31 du même circuit 32.

Le dispositif de l'invention permet donc coder chaque mot du train d'information de telle sorte que la disparité accumulée $\Sigma_n$ reste faible.

Dans un exemple particulier de réalisation on considère le dispositif de l'invention muni de 8 voies d'entrée.

Le circuit de calcul 11 de Sn et de -Sn est détaillé à la figure 2.

Les signaux véhiculés par les 8 voies sont, tout d'abord, entrés dans au moins un circuit de remise en forme 40.

Un premier circuit de calcul 41 permet ensuite d'obtenir le nombre N1 de "1" binaires présents dans un mot de rang n, deux voies par deux voies, de manière connue de l'homme de l'art. En effet si l'on considère deux voies V1 et V2, le poids fort de ce nombre est égal à V1.V2 et son poids faible à V1 + V2. Ce nombre N1 est ensuite calculé, à l'aide de circuits additionneurs 42 et 43, pour 2 fois 4 voies et enfin pour l'ensemble de 8 voies toujours pour un même mot de rang n. Ces circuits sont suivis d'un circuit de remise en forme 44.

Si l'on écrit les tables de vérité de Sn et de N1, pour 8 voies, l'on trouve, de manière connue de l'homme de l'art que Sn = N1-4 et donc que - Sn = 4 - N1 = $\overline{N1}$ + 5, en valeur complétée à 2. Les circuits 45 et 46 connus de l'homme de l'art permettent d'obtenir ces valeurs Sn et-Sn.

Un circuit de remise en forme et en phase 47 agit alors sur ces signaux Sn et-Sn.

Après calcul de $\Sigma_n = \Sigma_{n-1} + Sn$ et $\Sigma'_n = \Sigma_{n-1} - Sn$, les deux circuits échantillonneurs 18 et 19 permettent une remise en forme et en phase de $\Sigma_n$ de et $\Sigma'_n$.

La sélection de la valeur de $\Sigma_n$ en $\Sigma'_n$ s'effectue en fonction de la comparaison des signes de $\Sigma_{n-1}$ et de Sn.

La remise à zéro de l'une de ces deux valeurs permet, grâce à des "ou câblé" par exemple, d'obtenir la valeur de la disparité accumulée $\Sigma_n$ qui sera alors utilisé pour le calcul de $\Sigma_{n+1} = \Sigma_n \pm Sn$.

Le circuit d'inversion des digits du mot de rang n peut être réalisé à l'aide de circuits "ou exclusif" dont l'une des entrées est reliée à la sortie du circuit comparateur 22, le troisième échantillonneur 33 permettant alors une remise en forme des 8 voies auxquelles est jointe une 9è voie sur laquelle est envoyée le signal de sortie dudit circuit comparateur 22.

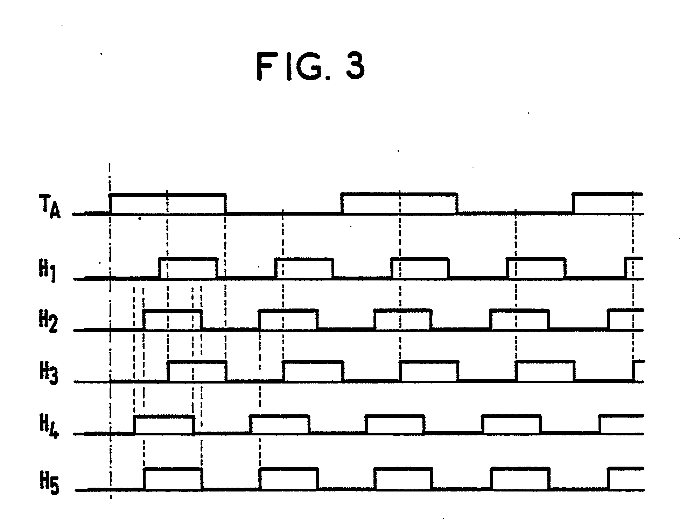

Le diagramme des temps représenté à la figure 3 correspond à un exemple de réalisation du dispositif de codage de l'invention en technologie ECL 100.000, pour un débit des trains affluents en 10 (TA) de 140 Mb/s (période = 7,2ns).

Le déphasage de $H_4$ par rapport à $H_3$ s'explique par le retard de 1,7 période à 140 Mb/s (12ns) introduit par les circuits 40, 41, 42, 43.

Le retard de $H_5$ par rapport à $H_4$ résulte du temps de propagation introduit par les circuits 44 et 45 (ou 46), qui est de l'ordre de 1,1 période (soit 7,5ns).

H2 se trouve en synchronisme avec H5 compte tenu des temps de propagation des circuits compris dans la boucle de calcul (1 période).

Le déphasage de H1 par rapport à H3 résulte du temps de propagation introduit par les circuits 30 et 32, qui est de l'ordre de 3,9 périodes à 140 Mb/s, soit 27,5ns environ.

Les trains d'impulsions binaires peuvent être transmis sur une voie en série, à une fréquence égale à x fois la fréquence de base et être démultiplexés en entrée du dispositif sous la forme de x trains d'informations parallèles.

**Revendications**

1/ Dispositif de mise en oeuvre d'un code à faible disparité accumulée en transmission numérique, à haut débit, d'informations groupées sous la forme de mots binaires de x digits, un mot de rang n ayant une somme Sn égale à la demi-différence entre le nombre de "1" et nombre de "0" de ce mot, ledit dispositif comprenant un circuit de calcul (11) de cette somme Sn, une unité de calcul (8) de la disparité accumulée

$$\Sigma_n = \sum_{k=0}^{n} Sk,$$

un circuit de comparaison (22) des signes de $\Sigma_{n-1}$ et de Sn, un circuit de codage (9) de ce mot de rang n, un circuit (37) délivrant des signaux d'horloge, caractérisé en ce que l'unité de calcul (8) de la disparité accumulée comprend une première unité de calcul (12, 18), de la somme $\Sigma_n = \Sigma_{n-1} + Sn$ et une deuxième unité de calcul (13, 19) de la différence $\Sigma'_n = \Sigma_{n-1} - Sn$ disposée en parallèle sur la première (12, 18), le circuit de comparaison (22) de signes de $\Sigma_{n-1}$ et de Sn ayant une sortie reliée directement à une entrée de remise à zéro de la première unité de calcul (12, 18), à une entrée de validation du circuit de codage (9), et à une entrée de ce même circuit de codage (9) pour former en sortie un x + 1e digit de ce mot, et indirectement, à travers un inverseur (26), à une entrée de remise à zéro de la deuxième unité de calcul (13, 19).

2/ Dispositif selon la revendication 1, caractérisé en ce que la transmission numérique se fait sur plusieurs voies (10) en parallèle, un mot étant alors formé de l'ensemble des informations qui arrivent simultanément sur ces voies (10).

3/ Dispositif selon l'une quelconque des revendications 1 et 2, caractérisé en ce que chaque unité de calcul de la somme $\Sigma_{n-1}$ + Sn ou de la différence $\Sigma_{n-1}$ - Sn comprend un circuit additionneur (12 ou 13) suivi d'un échantillonneur (18 ou 19).

4/ Dispositif selon l'une quelconque des revendications précédentes, caractérisé en ce que le circuit de calcul de Sn (11) comprend au moins un circuit de remise en forme (40), des circuits de calcul (41, 42, 43) du nombre (N1) de "1" d'un mot de rang n, un circuit de remise en forme (44), des circuits de calcul (45, 46) de Sn et - Sn, et au moins un circuit (47) de remise en forme et en phase de Sn et - Sn.

5/ Dispositif selon l'une quelconque des revendications précédentes, caractérisé en ce que le circuit de codage comprend un circuit (32) permettant en présence d'un signal de validation, l'inversion de tous les digits du mot de rang n, ce circuit étant suivi d'un échantillonneur (33).

6/ Dispositif selon la revendication 5, caractérisé en ce que le circuit de codage (32) comporte des circuits "ou exclusif".

7/ Dispositif selon l'une quelconque des revendications précédentes, caractérisé en ce que l'horloge génère, sur plusieurs sorties, des signaux décalés, respectivement reliées aux échantillonneurs (18, 19, 33) et aux circuit de remise en forme (40, 44, 47).

8/ Procédé de codage utilisant un dispcsitif selon l'une quelconque des revendications 1 à 7, caractérisé en ce que l'on calcule simultanément la somme $\Sigma_n = \Sigma_{n-1} + Sn$ et la différence $\Sigma'_n = \Sigma_{n-1} - Sn$, on effectue la comparaison entre le signe de $\Sigma_{n-1}$ et celui de Sn ; s'ils sont différents on remet à zéro $\Sigma'_n$ et on choisi $\Sigma_n$ comme nouvelle disparité accumulée ; s'ils sont égaux on remet à zéro $\Sigma_n$, on choisit $\Sigma'_n$ comme nouvelle disparité accumulée et on inverse tous les digits du mot de rang n.

**Claims**

1. A device for implementing a low accumulated disparity code for high data rate digital transmission of information grouped in the form of x-digit binary words, with an n-th word having a sum Sn equal to one half of the difference between the number of 1-bits and the number of 0-bits in said word, said device comprising a calculating circuit (11) for calculating said sum Sn, a calculating unit (8) for calculating the accumulated disparity

$$\Sigma_n = \sum_{k=0}^{k=n} Sk$$

a comparator circuit (22) for comparing the signs of $\Sigma_{n-1}$ and Sn, an encoding circuit for encoding the n-th word and a clock circuit (37) delivering clock signals, characterized in that the unit (8) for calculating the accumulated disparity comprises a first unit (12, 18) for calculating the sum $\Sigma_n = \Sigma_{n-1} + Sn$ and a second calculating unit (13, 19) for calculating the difference $\Sigma'_n = \Sigma_{n-1} - Sn$ disposed in parallel to the first unit (12, 18), the sign comparator circuit (22) for $\Sigma_{n-1}$ and Sn having an output which is directly connected to a reset to zero input for the first calculating unit (12, 18), to an enabling input of the encoding circuit (9), and to one of the inputs to said encoding circuit to form an (x+1)–th output bit of said word, and indirectly via an inverter (26) to a reset to zero input for the second calculating unit (13, 19).

2 A device according to claim 1, characterized in that the digital transmission takes place over a plurality of paths (10) in parallel, with a word then being formed by the set of data bits which arrive simultaneously via said paths (10).

3. A device according to any one of claims 1 and 2, characterized in that each unit for calculating the sum $\Sigma_{n-1}+Sn$ or the difference $\Sigma_{n-1}-Sn$ comprises an adder (12 or 13) followed by a sampler (18 or 19).

4. A device according to any one of the preceding claims, characterized in that the circuit for calculating Sn (11) comprises at least one shaping circuit (40), circuits (41, 42, 43) for calculating the number (N1) of 1-bits of a word having rank n, a shaping circuit (44), circuits (45, 46) for calculating Sn and −Sn and at least one circuit (47) for shaping and phase-adjusting Sn and −Sn.

5. A device according to any one of the preceding claims, characterized in that the encoding circuit comprises a circuit (32) which serves in the presence of an enabling signal to invert all the bits of the n−th word, this circuit being followed by a sampler (32).

6. A device according to claim 5, characterized in that the encoding circuit comprises EXCLUSIVE-OR gates.

7. A device according to any one of the preceding claims, characterized in that the clock provides on several outputs clock signals at different relative phase positions, said signals being applied to the samplers (18, 19, 33) and the shaping circuits (40, 44, 47).

8. An encoding method using a device according to any one of claims 1 to 7, characterized in that the sum $\Sigma_n = \Sigma_{n-1}+Sn$ and the difference $\Sigma'_n = \Sigma'_{n-1}-Sn$ are calculated simultaneously, that the signs of $\Sigma_{n-1}$ and Sn are compared and that in the case of non-identical signs, $\Sigma'_n$ is reset to zero and $\Sigma_n$ is selected as the new value of the accumulated disparity and in the case of identity of signs, $\Sigma_n$ is reset to zero and $\Sigma'_n$ is selected as the new value of the accumulated disparity and all of the bits of the n−th word are inverted.

**Patentansprüche**

1. Einrichtung zum Durchführen einer Kodierung mit geringer kumulierter Disparität im Rahmen der digitalen Übertragung großer Mengen von Informationen, die in Form von Binärwörtern zu X Bits gruppiert sind, wobei ein Wort des Rangs n eine Summe Sn bildet, welche der halben Differenz der Anzahl der 1-Bits und der Anzahl der 0-Bits dieses Worts entspricht, und die Einrichtung eine Schaltung (11) zum Berechnen dieser Summe Sn, eine Einheit (8) zum Berechnen der kumulierten Disparität

$$\Sigma_n = \sum_{k=0}^{k=n} Sk$$

eine Schaltung (22) zum Vergleichen der Vorzeichen von $\Sigma_{n-1}$ und Sn, eine Schaltung zum Verschlüsseln des Wortes des Rangs n und eine Schaltung (37) zum Ausgeben von Taktsignalen aufweist, dadurch gekennzeichnet, daß die Einheit (8) zum Berechnen der kumulierten Disparität eine erste Einheit (12, 18) zum Berechnen der Summe $\Sigma_n = \Sigma_{n-1}+Sn$ und eine zweite Einheit (13, 19) zum Berechnen der Differenz $\Sigma'_n = \Sigma_{n-1}-Sn$ parallel zur ersten Einheit (12, 18) aufweist, wobei die Schaltung (22) zum Vergleichen der Vorzeichen von $\Sigma_{n-1}$ und Sn einen Ausgang besitzt, der direkt an einen Nullrückstelleingang der ersten Recheneinheit (12, 18), an einen Freigabeeingang der Verschlüsselungsschaltung (9) und an einen weiteren Eingang der Verschlüsselungsschaltung zur Bildung eines (x+1)ten Bits dieses Wort am Ausgang, und indirekt, d.h. über einen Inverter (26), an einen Nullrückstelleingang der zweiten Recheneinheit (13, 19) angeschlossen ist.

2. Einrichtung nach Anspruch 1, dadurch gekennzeichnet, daß die digitale Datenübertragung über mehrere parallele Kanäle (10) erfolgt, so daß ein Wort aus der Gesamtheit der über diese Kanäle (10) gleichzeitig ankommenden Informationen gebildet wird.

3. Einrichtung nach Anspruch 1 oder 2, dadurch gekennzeichnet, daß jede Einheit zum Berechnen der Summe $\Sigma_{n-1}+Sn$ oder der Differenz $\Sigma_{n-1}-Sn$ eine Addierschaltung (12 oder 13) aufweist, auf die ein Probenabtaster (18 oder 19) folgt.

4. Einrichtung nach einem beliebigen der Ansprüche 1 bis 3, dadurch gekennzeichnet, daß die Berechnungsschaltung (11) für Sn mindestens eine Formwiederherstellungsschaltung (40), Rechenschaltungen (41, 42, 43) für die Anzahl (N1) der 1-Bits eines Wortes des Rangs n, eine Formwiederherstellungsschaltung (44), Rechenschaltungen (45, 46) für Sn und −Sn und mindestens eine Schaltung (47) zur Wiederherstellung der Form und Phasenlage von Sn und −Sn aufweist.

5. Einrichtung nach einem beliebigen der Ansprüche 1 bis 4, dadurch gekennzeichnet, daß die Verschlüsselungsschaltung eine Schaltung (32) aufweist, die es erlaubt, bei Vorliegen eines Freigabesignals die Umkehrung aller Bits des Wortes des Rangs n zu bewirken, und daß auf diese Schaltung ein Probenabtaster (33) folgt.

6. Einrichtung nach Anspruch 5, dadurch gekennzeichnet, daß die Verschlüsselungsschaltung (32) "Exklusiv-ODER"-Schaltungen aufweist.

7. Einrichtung nach einem beliebigen der Ansprüche 1 bis 6, dadurch gekennzeichnet, daß der Taktgeber zeitverschobene Signale an mehreren Ausgängen ausgibt, die mit den Probenabtastern (18, 19, 33) und den Formwiederherstellungsschaltungen (40, 44, 47) verbunden sind.

8. Verfahren zum Kodieren mit Hilfe einer Einrichtung nach einem der Ansprüche 1 bis 7, dadurch gekennzeichnet, daß gleichzeitig die Summe $\Sigma_n = \Sigma_{n-1}+Sn$ und die Differenz $\Sigma'_n = \Sigma_{n-1}-Sn$ berechnet und der Vergleich zwischen den Vorzeichen von $\Sigma_{n-1}$ und Sn durchgeführt wird, und daß im Fall unterschiedlicher Vorzeichen $\Sigma'_n$ auf Null zurückgestellt und $\Sigma_n$ als neue kumulierte Disparität gewählt wird, während im Fall gleicher Vorzeichen $\Sigma_n$ auf Null zurückgestellt und $\Sigma'_n$ als neue kumulierte Disparität gewählt wird, wobei alle Bits des Wortes des Rangs n invertiert werden.

# FIG.1

FIG. 2

| | | |
|---|---|---|
| H₃ | REMISE EN FORME | 40 |

CALCUL DU NOMBRE DE "1", 2 VOIES PAR 2 VOIES — 41

CALCUL DU NOMBRE DE "1", 4 VOIES PAR 4 VOIES — 42

CALCUL DU NOMBRE DE "1" sur 8 VOIES — 43

H₄ REMISE EN FORME — 44

45 — CALCUL DE Sn

46 — CALCUL DE – Sn

H₅ REMISE EN FORME ET EN PHASE — 47

HORLOGE — 37

Sn          –Sn

10

11

# FIG. 3